(19) Europäisches Patentamt
European Patent Office
Office européen des brevets

(11) EP 4 026 865 B1

(12) **EUROPEAN PATENT SPECIFICATION**

(45) Date of publication and mention of the grant of the patent:
**09.08.2023 Bulletin 2023/32**

(21) Application number: **20860888.5**

(22) Date of filing: **27.08.2020**

(51) International Patent Classification (IPC):
***C08G 59/30*** (2006.01) ***C08G 59/40*** (2006.01)
***C08G 59/62*** (2006.01) ***C08G 59/32*** (2006.01)
***C08K 3/22*** (2006.01) ***C08K 9/02*** (2006.01)
***C08G 59/68*** (2006.01) ***C08J 5/24*** (2006.01)
***C08K 3/36*** (2006.01) ***C08L 63/00*** (2006.01)
***H05K 1/03*** (2006.01) ***H05K 3/02*** (2006.01)

(52) Cooperative Patent Classification (CPC):
(C-Sets available)
**C08G 59/4021; C08G 59/304; C08G 59/3272; C08G 59/621; C08G 59/686; C08J 5/244; C08K 9/02; C08L 63/00; H05K 1/0373;**
C08J 2363/00; C08J 2363/04; C08K 3/22; C08K 3/36; C08K 2003/2224; C08K 2003/2227;

(Cont.)

(86) International application number:
**PCT/JP2020/032437**

(87) International publication number:
**WO 2021/044946 (11.03.2021 Gazette 2021/10)**

# (54) RESIN COMPOSITION, PREPREG, RESIN-EQUIPPED FILM, RESIN-EQUIPPED METAL FOIL, METAL-CLADDED LAMINATED PLATE, AND PRINTED WIRING BOARD

HARZZUSAMMENSETZUNG, PREPREG, HARZBESCHICHTETE FOLIE, HARZBESCHICHTETE METALLFOLIE, METALLBESCHICHTETE LAMINIERTE PLATTE UND LEITERPLATTE

COMPOSITION DE RÉSINE, PRÉIMPRÉGNÉ, FILM REVÊTU DE RÉSINE, FEUILLE MÉTALLIQUE REVÊTUE DE RÉSINE, FEUILLE STRATIFIÉE PLAQUÉE DE MÉTAL, ET CARTE DE CIRCUIT IMPRIMÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.09.2019 JP 2019163408**

(43) Date of publication of application:
**13.07.2022 Bulletin 2022/28**

(73) Proprietor: **Panasonic Intellectual Property Management Co., Ltd.**
**Osaka-shi, Osaka 540-6207 (JP)**

(72) Inventors:
- **IRIFUNE, Akira**
**Osaka-shi, Osaka 540-6207 (JP)**
- **SAGARA, Takashi**
**Osaka-shi, Osaka 540-6207 (JP)**
- **NAKASHIMA, Takayuki**
**Osaka-shi, Osaka 540-6207 (JP)**
- **ENDOU, Kazuei**
**Osaka-shi, Osaka 540-6207 (JP)**
- **HANAZAKI, Shohei**
**Osaka-shi, Osaka 540-6207 (JP)**

(74) Representative: **Appelt, Christian W.**
**Boehmert & Boehmert Anwaltspartnerschaft mbB**
**Pettenkoferstrasse 22**
**80336 München (DE)**

(56) References cited:
**WO-A1-2011/118584** **WO-A1-2013/001726**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**JP-A- 2014 236 090**

(52) Cooperative Patent Classification (CPC): (Cont.)
H05K 1/0366; H05K 3/022; H05K 2201/0209

C-Sets
**C08K 3/22, C08L 63/00;**
**C08K 9/02, C08L 63/00;**
**C08K 9/02, C08L 85/02;**
**C08L 63/00, C08K 3/36, C08K 2003/2224, C08K 2003/2227;**
C08K 3/22, C08L 85/02

## Description

### Technical Field

The present disclosure generally relates to a resin composition, a prepreg, a film with resin, a sheet of metal foil with resin, a metal-clad laminate, and a printed wiring board. More particularly, the present disclosure relates to a resin composition containing an epoxy resin, curing agent, and an inorganic filler, a prepreg, a film with resin, a sheet of metal foil with resin, a metal-clad laminate, and a printed wiring board.

### Background Art

Patent Literature 1 discloses a prepreg, of which a sheet-shaped base member is impregnated with a phosphorus-containing epoxy resin composition. The phosphorus-containing epoxy resin composition contains a phosphorus-containing epoxy resin and a curing agent. The phosphorus-containing epoxy resin is obtained by producing a reaction between a phosphorus-containing organic compound and a type of epoxy resin. Furthermore, the phosphorus-containing organic compound is obtained by producing a reaction between a type of quinone compound and a type of organic phosphorus compound having an active hydrogen atom bonded to a phosphorus atom.

The prepreg of Patent Literature 1 contains the phosphorus-containing epoxy resin. Thus, a printed wiring board formed by using this prepreg would have flame retardance.

However, the printed wiring board of Patent Literature 1 still has room for improvement in terms of drillability and desmear performance.

If the drillability is poor, then the drill wear rate tends to rise, thus requiring replacement of a drill bit more frequently and possibly causing a decline in the productivity of the printed wiring board. In addition, if the drillability is poor, then a through hole having a desired hole diameter could not be formed.

On the other hand, if the desmear performance is poor, then the smear could be removed either insufficiently or excessively to the contrary.

Furthermore, the poor drillability and desmear performance could have a harmful effect on ion migration. Directly speaking, the "ion migration" refers to a phenomenon that the migration of ions between the electrodes of a printed wiring board causes precipitation of a metal that leads to deterioration of electrical insulation properties. If the drillability and the desmear performance are poor, then the ion migration occurs more frequently.

WO 2011/118584 A1 discloses compositions comprising an epoxy resin including a phosphorous-containing epoxy resin and dicyandiamide as a curing agent, prepregs and multilayer printed circuit boards made therefrom, wherein drillability is addressed.

### Citation List

### Patent Literature

Patent Literature 1: JP 2001-288247 A

### Summary of Invention

It is therefore an object of the present disclosure to provide a resin composition, a prepreg, a film with resin, a sheet of metal foil with resin, a metal-clad laminate, and a printed wiring board, all of which contribute to reducing the chances of causing the ion migration and improving the drillability, desmear performance, and flame retardance.

A resin composition according to an aspect of the present disclosure contains an epoxy resin, a curing agent, and an inorganic filler. The epoxy resin includes a phosphorus-containing epoxy resin. The curing agent includes dicyandiamide. The inorganic filler includes: a silica-treated magnesium hydroxide that is a magnesium hydroxide subjected to surface treatment with silica; and aluminum hydroxide. Total content of the silica-treated magnesium hydroxide and the aluminum hydroxide falls within a range from 30 parts by mass to 80 parts by mass with respect to 100 parts by mass in total of the epoxy resin and the curing agent.

A prepreg according to another aspect of the present disclosure includes: a resin layer containing the resin composition described above; and a base member impregnated with the resin composition.

A film with resin according to still another aspect of the present disclosure includes: a resin layer containing the resin composition described above; and a supporting film to support the resin layer.

A sheet of metal foil with resin according to yet another aspect of the present disclosure includes: a resin layer containing the resin composition described above; and a sheet of metal foil bonded to the resin layer.

A metal-clad laminate according to yet another aspect of the present disclosure includes: an insulating layer

containing either a cured product of the resin composition described above or a cured product of the prepreg described above; and a metal layer bonded to the insulating layer.

Aprinted wiring board according to yet another aspect of the present disclosure includes:

an insulating layer containing either a cured product of the resin composition described above or a cured product of the prepreg described above; and conductor wiring bonded to the insulating layer.

**Brief Description of Drawings**

FIG. 1 is a schematic cross-sectional view illustrating a prepreg according to an exemplary embodiment of the present disclosure;
FIG. 2A is a schematic cross-sectional view illustrating a film with resin (and with no protective film) according to the exemplary embodiment of the present disclosure;
FIG. 2B is a schematic cross-sectional view illustrating a film with resin (and with a protective film) according to the exemplary embodiment of the present disclosure;
FIG. 3 is a schematic cross-sectional view illustrating a sheet of metal foil with resin according to the exemplary embodiment of the present disclosure;
FIG. 4 is a schematic cross-sectional view illustrating a metal-clad laminate according to the exemplary embodiment of the present disclosure; and
FIG. 5 is a schematic cross-sectional view illustrating a printed wiring board according to the exemplary embodiment of the present disclosure.

**Description of Embodiments**

(1) Overview

A resin composition according to an exemplary embodiment may be used mainly as a material for a printed wiring board 5 (see FIG. 5). Specific examples of materials for the printed wiring board 5 include a prepreg 1, a film 2 with resin, a sheet of metal foil 3 with resin, and a metal-clad laminate 4 (see FIGS. 1-4). However, these are only examples and should not be construed as limiting.

A resin composition according to this embodiment contains an epoxy resin, a curing agent, and an inorganic filler. The epoxy resin includes a phosphorus-containing epoxy resin. The curing agent includes dicyandiamide. The inorganic filler includes a silica-treated magnesium hydroxide and aluminum hydroxide. The silica-treated magnesium hydroxide is a magnesium hydroxide subjected to surface treatment with silica. Total content of the silica-treated magnesium hydroxide and the aluminum hydroxide falls within a range from 30 parts by mass to 80 parts by mass with respect to 100 parts by mass in total of the epoxy resin and the curing agent.

The resin composition according to this embodiment may reduce the chances of causing the ion migration and thereby improve the drillability, desmear performance, and flame retardance.

As used herein, the "ion migration" could be caused by dendrite and CAF (conductive anodic filament) from the viewpoint of its generation form. Dendrites are dendritic metals precipitated between parallel electrodes on the surface of the board. Dendrites are mainly generated on the surface of the board (in, for example, portion Y shown in FIG. 5). On the other hand, in CAF, metal ions precipitated from the anode are precipitated mainly at the boundary between the glass fiber and the resin in the inner layer of the board. CAP is mainly generated in the inner layer of the board (in, for example, portion X shown in FIG. 5).

(2) Details

<Resin composition>

The resin composition contains an epoxy resin, a curing agent, and an inorganic filler. The resin composition may further contain a curing accelerator. The resin composition has thermosetting properties. When heated, the resin composition turns into a semi-cured product. When further heated, the resin composition turns into a cured product. The semi-cured product is a substance in a semi-cured state, and the cured product is a substance in a cured state (insoluble and non-meltable state). As used herein, the semi-cured state refers to a state in an intermediate stage (stage B) of the curing reaction. The intermediate stage is a stage between a varnished stage (stage A) and a cured stage (stage C).

Next, respective constituent components of the resin composition will be described.

<<Epoxy resin>>

The epoxy resin (epoxy compound) is a prepolymer and is a compound having at least two epoxy groups in its molecule. Generally speaking, the term "resin" refers to two different types of resins, namely, a resin as a material yet to be cross-linked and a resin as a cross-linked product (final product). As used herein, the "resin" basically refers to the former type of a resin.

The epoxy resin includes a phosphorus-containing epoxy resin. A phosphorus-containing epoxy resin is a resin having two or more epoxy groups and one or more phosphorus atoms in its molecule. When the epoxy resin includes such a phosphorus-containing epoxy resin, the flame retardance may be improved even if the epoxy resin contains no halogens.

The phosphorus content of the phosphorus-containing epoxy resin preferably falls within the range from 0.5% by mass to less than 5% by mass, and more preferably falls within the range from 1.5% by mass to 3% by mass. Setting the phosphorus content at 0.5% by mass or more allows further improving the flame retardance. Setting the phosphorus content at a value less than 5% by mass allows curbing a decrease in heat resistance. In other words, this may curb a decrease in glass transition temperature (Tg).

Preferably, the phosphorus-containing epoxy resin has, in its molecule, the structure expressed by the following Formula (1) and/or the structure expressed by the following Formula (2). This may further improve the flame retardance. More preferably, the phosphorus-containing epoxy resin has, in its molecule, at least the structure expressed by the following Formula (1). Optionally, the phosphorus-containing epoxy resin may have, in its molecule, a plurality of structures each expressed by the following Formula (1) and/or a plurality of structures each expressed by the following Formula (2).

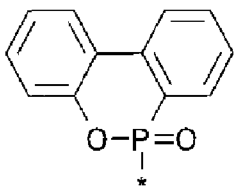

(1)

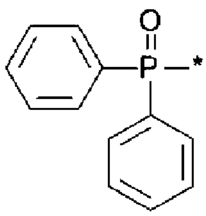

(2)

where * indicates a bond.

Preferably, the phosphorus-containing epoxy resin has a naphthalene structure in its molecule. This may improve the heat resistance. The heat resistance is improved probably because the naphthalene structure, which is a condensed polycyclic structure, would decrease the molecular motion to cause an increase in glass transition temperature (Tg).

Preferably, the phosphorus-containing epoxy resin has, in its molecule, the structure expressed by the following Formula (3). Since the structure expressed by the following Formula (3) has the structure expressed by the Formula (1) and the naphthalene structure, the flame retardance and heat resistance may be further improved.

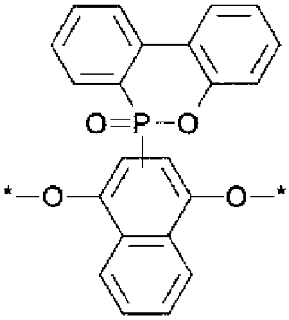

(3)

where * indicates a bond.

The epoxy resin may contain an epoxy resin other than the phosphorus-containing epoxy resin (hereinafter referred to as a "phosphorus-free epoxy resin"). The phosphorus-free epoxy resin may be, but does not have to be, selected from the group consisting of, for example, naphthalene type epoxy resins, cresol novolac type epoxy resins, bisphenol A type epoxy resins, bisphenol F type epoxy resins, bisphenol S type epoxy resins, phenol novolac type epoxy resins, alkyl phenol novolac type epoxy resins, aralkyl type epoxy resins, biphenol type epoxy resins, dicyclopentadiene type epoxy resins, epoxidized products of condensate of phenols and aromatic aldehyde having a phenolic hydroxyl group, triglycidyl isocyanurate, and alicyclic epoxy resins. The epoxy resin may include at least one phosphorus-free epoxy resin selected from this group.

<<Curing agent>>

The curing agent contains dicyandiamide. This may improve the adhesion and flame retardance. In particular, the adhesion and flame retardance may be improved, compared to a situation where the curing agent contains a phenolic resin (for example, a novolac type phenolic resin) instead of dicyandiamide.

As used herein, the "adhesion" refers to the adhesion between an insulating layer 41 and a metal layer 43 in a metal-clad laminate 4 and the adhesion between an insulating layer 51 and conductor wiring 53 in a printed wiring board 5. That is to say, if the curing agent contains dicyandiamide, the adhesion between the insulating layer 41 and the metal layer 43 improves in the metal-clad laminate 4. In addition, the adhesion between the insulating layer 51 and the conductor wiring 53 also improves in the printed wiring board 5. As used herein, the "insulating layer" refers to a layer having electrical insulation properties.

The total amount of active hydrogen groups in the curing agent is not limited to any particular value but preferably falls within the range from 0.2 equivalents to 0.5 equivalents with respect to 1 equivalent of the epoxy group of the epoxy resin. Setting the total amount of active hydrogen groups in the curing agent at 0.2 equivalents or more allows curbing a decrease in heat resistance and adhesion. On the other hand, setting the total amount of active hydrogen groups of the curing agent at 0.5 equivalents or less allows curbing a decrease in adhesion, flame retardance, and moldability. Specifically, as for moldability, this may reduce the chances of the gel time becoming too short. Further, the total amount of active hydrogen groups of dicyandiamide contained in the curing agent preferably falls within the range from 0.2 equivalents to 0.5 equivalents with respect to 1 equivalent of the epoxy groups of the epoxy resin.

<<Inorganic filler>>

The inorganic filler contains a silica-treated magnesium hydroxide and aluminum hydroxide. The silica-treated magnesium hydroxide and aluminum hydroxide impart flame retardance to the cured product of the resin composition by having the heat of combustion absorbed into the decomposed water produced during heating. Among other things, the aluminum hydroxide increases the flame retardance particularly effectively.

The silica-treated magnesium hydroxide is a magnesium hydroxide subjected to surface treatment with silica such as colloidal silica. The silica-treated magnesium hydroxide includes a magnesium hydroxide having silica on its surface and a magnesium hydroxide having a composite of silica and alumina on its surface.

As used herein, the expression "magnesium hydroxide has silica on its surface" means, for example, that the silica adheres to the surface of the magnesium hydroxide. Furthermore, the forms of adhesion include, for example, coating and supporting.

Preferably, the surface of the magnesium hydroxide is coated with the silica. In that case, the silica forms a layer, for example. When the silica forms a layer, the layer may be formed by particles of the silica that are connected together. The silica may coat the surface of the magnesium hydroxide at least partially. That is to say, the surface of the magnesium hydroxide may be coated with the silica either entirely or only partially, whichever is appropriate.

On the other hand, the expression "the silica is supported on the magnesium hydroxide" herein means that a powdered silica is fixed on the surface of the magnesium hydroxide serving as a catalytic support. In this case, the silica may be supported on at least a part of the surface of the magnesium hydroxide. That is to say, the silica may be supported on the entire surface, or only a part of the surface, of the magnesium hydroxide, whichever is appropriate.

The magnesium hydroxide in the silica-treated magnesium hydroxide may contribute to reducing the chances of causing the ion migration. On the other hand, the silica in the silica-treated magnesium hydroxide may contribute to improving the desmear performance. If the surface is not treated with the silica, then the smear would tend to be removed excessively, thus possibly resulting in a hole with a deformed shape or too large a diameter through the desmear process.

The mean particle size of the silica-treated magnesium hydroxide preferably falls within the range from 0.5 $\mu$m to 10 $\mu$m, and more preferably falls within the range from 1.0 $\mu$m to 5.0 $\mu$m. As used herein, the "mean particle size" refers to the particle size at a cumulative value of 50% in the particle size distribution obtained by laser diffraction/scattering method.

Preferably, the silica content of the silica-treated magnesium hydroxide falls within the range from 1 part by mass to 10 parts by mass with respect to 100 parts by mass of the magnesium hydroxide. Setting the silica content at 1 part by mass or more allows the surface of the magnesium hydroxide to be sufficiently treated and reduces the chances of removing smear excessively through the desmear process. On the other hand, setting the silica content at 10 parts by mass or less not only allows curbing a decrease in flame retardance but also reduces the chances of causing the ion migration.

The total content of the silica-treated magnesium hydroxide and the aluminum hydroxide falls within the range from 30 parts by mass to 80 parts by mass with respect to 100 parts by mass in total of the epoxy resin and the curing agent.

If the total content of the silica-treated magnesium hydroxide and the aluminum hydroxide were less than 30 parts by mass, the flame retardance could decrease. In addition, the coefficient of linear expansion could increase. In particular, the coefficients of linear expansion (CTE-Z) of the metal-clad laminate 4 and the printed wiring board 5 in the thickness direction tend to increase.

On the other hand, if the total content of the silica-treated magnesium hydroxide and the aluminum hydroxide were greater than 80 parts by mass, the drillability could decrease. Specifically, the drill wear rate would tend to increase. In addition, the adhesion could also decrease. Besides, the heat resistance could decrease as well.

The content of the silica-treated magnesium hydroxide preferably falls within the range from 1 part by mass to 50 parts by mass, more preferably falls within the range from 2 parts by mass to 30 parts by mass, with respect to 100 parts by mass in total of the silica-treated magnesium hydroxide and the aluminum hydroxide. Setting the content of the silica-treated magnesium hydroxide at 1 part by mass or more allows further reducing the chances of causing the ion migration. On the other hand, setting the content of the silica-treated magnesium hydroxide at 50 parts by mass or less allows curbing a decrease in flame retardance.

<<Curing accelerator>>

The curing accelerator may be, but does not have to be, selected from the group consisting of, for example: imidazoles such as 2-ethyl-4-methylimidazole, 2-methylimidazole, 2-phenyl-4-methylimidazole; amines such as dimethylbenzylamine, triethylenediamine, benzyldimethylamine, and triethanolamine; organic phosphines such as triphenylphosphine, diphenylphosphine, and phenylphosphine; tetra-substituted phosphonium-tetra-substituted borates such as tetraphenylphosphonium ethyltriphenyl borate; and tetraphenyl boron salts such as 2-ethyl-4-methylimidazole tetraphenylborate. The curing accelerator may include at least one selected from this group. When the resin composition contains a curing accelerator, the content of the curing accelerator may, but does not have to, fall within the range from 0.01 parts by mass to 0.1 parts by mass with respect to 100 parts by mass in total of the epoxy resin and the curing agent.

<Prepreg>

FIG. 1 illustrates a prepreg 1 according to this embodiment. The prepreg 1 has the shape of a sheet. The prepreg 1 includes at least one sheet of base member 12 and a resin layer 11. The base member 12 is impregnated with the resin composition. The resin layer 11 contains the resin composition. The resin composition is a semi-cured product.

The base member 12 is a reinforcing member and is not limited to any particular one. The base member 12 may, but does not have to, have a thickness preferably falling within the range from 10 $\mu$m to 300 $\mu$m, and more preferably falling within the range from 30 $\mu$m to 200 $\mu$m.

Specific examples of the base member 12 include glass cloth, aramid cloth, polyester cloth, glass non-woven fabric, aramid non-woven fabric, polyester non-woven fabric, pulp paper, and linter paper. The types of glass cloth are preferably #7628, #1501, #2116, #1080, #1078, and #106.

In the manufacturing process of the prepreg 1, the glass cloth is preferably treated with a coupling agent before

being impregnated with the resin composition in stage A. Treating the glass cloth with the coupling agent in this manner may increase the degree of adhesion between the glass cloth and the resin composition.

Preferably, the coupling agent has, in one molecule, a reactive group that chemically bonds to an inorganic material and a reactive group that chemically bonds to an organic material. Specific examples of the reactive group that chemically bonds to the inorganic material include an ethoxy group and a methoxy group. Specific examples of the reactive group that chemically bonds to the organic material include an epoxy group, an amino group, an isocyanate group, a hydroxy group, and an acid anhydride group.

Specifically, the coupling agent is a silane coupling agent. The silane coupling agent may include, for example, an epoxy silane, an amino silane, an isocyanate silane, or an acid anhydride silane. Specific examples of the epoxy silane include 3-glycidoxypropyl trimethoxysilane. Specific examples of the amino silane include 3-aminopropyltriethoxysilane. Specific examples of the isocyanate silane include 3-isocyanatepropyltriethoxysilane.

A method for manufacturing the prepreg includes the steps of: impregnating the base member 12 with a resin composition in stage A; and heating the base member 12 until the resin composition impregnated into the base member 12 makes a transition to stage B. As used herein, the stage A refers to an initial stage on which the resin composition is soluble in a certain type of liquid and meltable. That is to say, the resin composition in stage A is a varnish.

<Film with resin>

FIGS. 2A and 2B illustrate films 2 with resin according to this embodiment. Each of the films 2 with resin may be used, for example, to form a printed wiring board 5 with multiple levels (by buildup process). The film 2 with resin has the shape of a film as a whole. The film 2 with resin includes a resin layer 21 and a supporting film 22. FIG. 2A illustrates a film 2 with resin and with no protective film 23. FIG. 2B illustrates a film 2 with resin and with a protective film 23 as an additional member. Peeling the protective film 23 from the film 2 with resin shown in FIG. 2B may turn the film 2 with resin shown in FIG. 2B into the film 2 with resin shown in FIG. 2A.

The resin layer 21 contains the resin composition. The resin composition is a semi-cured product. When heated, the semi-cured product turns into a cured product. In this manner, the resin layer 21 may form an insulating layer.

The thickness of the resin layer 21 is not limited to any particular value but is preferably 120 μm or less, more preferably 100 μm or less, even more preferably 60 μm or less, and most preferably 40 μm or less. This allows the insulating layer to have a reduced thickness, thus reducing the overall thickness of the board as well. The resin layer 21 preferably has a thickness of 10 μm or more.

The supporting film 22 supports the resin layer 21 thereon. Making the supporting film 22 support the resin layer 21 in this way allows the resin layer 21 to be handled more easily.

The supporting film 22 may be an electrically insulating film, for example. Specific examples of the supporting film 22 include a polyethylene terephthalate (PET) film, a polyimide film, a polyester film, a polyparabanic acid film, a polyether ether ketone film, a polyphenylene sulfide film, an aramid film, a polycarbonate film, and a polyarylate film. However, these are only examples and the supporting film 22 does not have to be one of these films.

A release agent layer (not shown) may be provided on the surface, used to support the resin layer 21, of the supporting film 22. The release agent layer allows the supporting film 22 to be peeled off as appropriate from the resin layer 21. After the resin layer 21 has been cured to form the insulating layer, the supporting film 22 is preferably peeled off from the insulating layer.

Although one surface of the resin layer 21 is covered with the supporting film 22 in the example shown in FIG. 2A, the other surface of the resin layer 21 may be covered with a protective film 23 as shown in FIG. 2B. Covering both surfaces of the resin layer 21 in this manner with the supporting film 22 and the protective film 23, respectively, allows the resin layer 21 to be handled even more easily. This also reduces the chances of foreign particles adhering onto the resin layer 21.

The protective film 23 may be, but does not have to be, an electrically insulating film, for example. Specific examples of the protective film 23 include a polyethylene terephthalate (PET) film, a polyolefin film, a polyester film, and a polymethylpentene film. However, these are only examples and the protective film 23 does not have to be one of these films.

A release agent layer (not shown) may be provided on the surface, laid on top of the resin layer 21, of the protective film 23. The release agent layer allows the protective film 23 to be peeled off as appropriate from the resin layer 21.

<Sheet of metal foil with resin>

FIG. 3 illustrates a sheet of metal foil 3 with resin according to this embodiment. The sheet of metal foil 3 with resin has the shape of a film as a whole. The sheet of metal foil 3 with resin includes a resin layer 31 and a sheet of metal foil 32. The sheet of metal foil 3 with resin may be used to form a printed wiring board 5 with multiple levels (by

buildup process).

The resin layer 31 contains the resin composition. The resin composition is a semi-cured product. When heated, the semi-cured product may turn into a cured product. In this manner, the resin layer 31 may form an insulating layer.

The thickness of the resin layer 31 is not limited to any particular value but is preferably 120 μm or less, more preferably 100 μm or less, even more preferably 60 μm or less, and most preferably 40 μm or less. This allows the insulating layer, which is formed by curing the resin layer 31, to have a reduced thickness, thus reducing the overall thickness of the board as well. The resin layer 31 preferably has a thickness of 10 μm or more.

The sheet of metal foil 32 is bonded to the resin layer 31. The sheet of metal foil 32 may specifically be, but does not have to be, a sheet of copper foil. The sheet of metal foil 32 may be patterned into conductor wiring by having unnecessary portions thereof etched away by subtractive process, for example.

The thickness of the sheet of metal foil 32 is not limited to any particular value but is preferably 35 μm or less, and more preferably 18 μm or less. The sheet of metal foil 32 preferably has a thickness of 5 μm or more.

Optionally, the sheet of metal foil 32 may be configured as an extremely thin sheet of metal foil (such as an extremely thin sheet of copper foil) of a so-called "extremely thin sheet of metal foil with a carrier (not shown)." The extremely thin sheet of metal foil with the carrier has a triple layer structure. That is to say, the extremely thin sheet of metal foil with the carrier includes: the carrier; a peelable layer provided on the surface of the carrier; and an extremely thin sheet of metal foil provided on the surface of the peelable layer. The extremely thin sheet of metal foil is too thin to be handled easily by itself and is naturally thinner than the carrier. The carrier is a sheet of metal foil (such as a sheet of copper foil) that plays the role of protecting and supporting the extremely thin sheet of metal foil. The extremely thin sheet of metal foil with the carrier is relatively thick and thick enough to handle easily. The thicknesses of the extremely thin sheet of metal foil and the carrier are not limited to any particular values. For example, the extremely thin sheet of metal foil may have a thickness falling within the range from 1 μm to 10 μm, for example, and the carrier may have a thickness falling within the range from 18 μm to 35 μm. The extremely thin sheet of metal foil may be peeled off as appropriate from the peelable layer.

When the extremely thin sheet of metal foil with the carrier is used, the sheet of metal foil 3 with resin may be manufactured in the following manner. Specifically, the resin composition is applied onto the surface of the extremely thin sheet of metal foil of the extremely thin sheet of metal foil with the carrier and heated to form a resin layer 31. Thereafter, the carrier is peeled off from the extremely thin sheet of metal foil. The extremely thin sheet of metal foil is bonded as a sheet of metal foil 32 to the surface of the resin layer 31. The peelable layer is preferably peeled off along with the carrier and should not be left on the surface of the extremely thin sheet of metal foil. Nevertheless, even if any part of the peelable layer remains on the surface of the extremely thin sheet of metal foil, the remaining part of the peelable layer is easily removable. The extremely thin sheet of metal foil bonded to the surface of the resin layer 31 may be used as a seed layer in a modified semi-additive process (MSAP). The conductor wiring may be formed by subjecting the seed layer to an electrolytic plating process.

<Metal-clad laminate>

FIG. 4 illustrates a metal-clad laminate 4 according to this embodiment. The metal-clad laminate 4 includes an insulating layer 41 and a metal layer 43. The insulating layer 41 includes a cured product of at least one prepreg 1. As can be seen, the metal-clad laminate 4 may be manufactured, for example, with the prepreg 1 used as its material. The insulating layer 41 is a layer that has electrical insulation properties and is in an insoluble and non-meltable state. The metal layer 43 is bonded to the insulating layer 41.

The metal layer 43 is not limited to any particular one as long as the metal layer 43 is a layer containing a metal. Specifically, the metal layer 43 may be a sheet of copper foil. The metal layer 43 preferably has a thickness falling within the range from 18 μm to 210 μm. The ten-point average roughness Rzjis of the metal layer 43 is preferably 5.0 μm or more. This may further increase the degree of adhesion between the insulating layer 41 and the metal layer 43.

A method for manufacturing the metal-clad laminate 4 includes the step of stacking a metal layer 43 such as a sheet of metal foil on one or both sides of a laminate made up of either one prepreg 1 or two or more prepregs 1 and heating and pressing the metal layer 43, for example. Preferably, before the metal layer 43 is stacked on the laminate, the surface of the metal layer 43 (at least its surface to be laid on the laminate) is treated with a coupling agent. Treating the surface of the metal layer 43 with the coupling agent in this manner causes the coupling agent to bond the organic material in the prepreg 1 to the metal layer 43, thus further increasing the degree of adhesion between the insulating layer 41 and the metal layer 43. As the coupling agent, any of the exemplary ones described above may be used. The condition for heating and pressing is not limited to any particular one. FIG. 4 illustrates a metal-clad laminate 4 obtained through the step of stacking a metal layer 43 on each of the two sides of the laminate consisting of one prepreg 1 and then heating and pressing the metal layer 43.

<Printed wiring board>

FIG. 5 illustrates a printed wiring board 5 according to this embodiment. The printed wiring board 5 includes at least one insulating layer 51 and at least one conductor layer 530. The insulating layer 51 includes a cured product of at least one prepreg 1. The insulating layer 51 is a layer having electrical insulation properties and exhibiting an insoluble and non-meltable state. The conductor layer 530 is bonded to the insulating layer 51. As used herein, the "conductor layer" refers to a layer with electrical conductivity such as a signal layer, a power supply layer, or a ground layer. Also, as used herein, the printed wiring board 5 may also be a multilevel printed wiring board including three or more conductor layers 530. Note that a printed wiring board including two conductor layers 530 and the insulating layer 51 is shown in FIG. 5.

The printed wiring board 5 may be manufactured by, for example, a subtractive process using the metal-clad laminate 4 as its material. Alternatively, the printed wiring board 5 may also be formed to have a multi-layer structure by a build-up process using the film 2 with resin and the sheet of metal foil 3 with resin.

The printed wiring board 5 may have one or more pieces of through hole plating 54. The through hole plating 54 may be formed by, for example, drilling a hole through the insulating layer 51, performing a desmear process on the hole, and then plating the inner wall of the hole with copper, for instance. The desmear process may be performed by, for example, permanganate method. Although not shown, the printed wiring board 5 may have one or more blind via holes. Note that the hole may be a through hole or a non-through hole, whichever is appropriate.

In this case, the insulating layer 51 has good drillability, which may reduce an increase in drill wear rate when a hole is drilled open through the insulating layer 51. Reducing an increase in drill wear rate leads to reducing an increase in the cutting temperature of the insulating layer 51, thus reduces the chances of leaving smear. In addition, reducing an increase in drill wear rate requires replacing the drill bit less often, thus contributing to increasing the productivity of the printed wiring boards 5.

Furthermore, since the insulating layer 51 has good desmear performance, the smear may be removed sufficiently when the hole is subjected to the desmear process. This reduces the chances of having conductivity failures caused by the residual smear. In addition, this also reduces the chances of removing the inner wall of the hole excessively when the hole is subjected to the desmear process. Thus, the hole rarely comes to have a deformed shape or an excessively increased hole diameter.

Besides, since the insulating layer 51 has good drillability and desmear performance, the ion migration rarely happens. Specifically, this reduces the chances of forming CAF along the base member 52 inside the insulating layer 51 (e.g., in the portion X shown in FIG. 5) and forming dendrites outside the insulating layer 51 (e.g., in the portion Y shown in FIG. 5). Consequently, this may increase the long-term insulation reliability of the printed wiring board 5.

As can be seen from the foregoing description, this embodiment contributes to reducing the chances of causing the ion migration and thereby improving the drillability, desmear performance, and flame retardance.

(Recapitulation)

As can be seen from the foregoing description of embodiments, the present disclosure has the following aspects. In the following description, reference signs are inserted in parentheses just for the sake of clarifying correspondence in constituent elements between the following aspects of the present disclosure and the exemplary embodiments described above.

A resin composition according to a first aspect contains an epoxy resin, a curing agent, and an inorganic filler. The epoxy resin includes a phosphorus-containing epoxy resin. The curing agent includes dicyandiamide. The inorganic filler includes: a silica-treated magnesium hydroxide that is a magnesium hydroxide subjected to surface treatment with silica; and aluminum hydroxide. Total content of the silica-treated magnesium hydroxide and the aluminum hydroxide falls within a range from 30 parts by mass to 80 parts by mass with respect to 100 parts by mass in total of the epoxy resin and the curing agent.

This aspect may contribute to reducing the chances of causing the ion migration and thereby improving the drillability, desmear performance, and flame retardance.

In a resin composition according to a second aspect, which may be implemented in conjunction with the first aspect, a total amount of active hydrogen groups in the curing agent falls within a range from 0.2 equivalents to 0.5 equivalents with respect to 1 equivalent of an epoxy group in the epoxy resin.

According to this aspect, setting the total amount of active hydrogen groups in the curing agent at 0.2 equivalents or more may reduce the chances of causing a decline in heat resistance and adhesion. On the other hand, setting the total amount of active hydrogen groups in the curing agent at 0.5 equivalents or less may reduce the chances of causing a decline in moldability.

In a resin composition according to a third aspect, which may be implemented in conjunction with the first or second aspect, content of the silica-treated magnesium hydroxide falls within a range from 1 part by mass to 50 parts

by mass with respect to 100 parts by mass in total of the silica-treated magnesium hydroxide and the aluminum hydroxide.

According to this aspect, setting the content of the silica-treated magnesium hydroxide at 1 part by mass or more may further reduce the chances of causing the ion migration. On the other hand, setting the content of the silica-treated magnesium hydroxide at 50 parts by mass or less may further reduce the chances of causing a decline in flame retardance.

In a resin composition according to a fourth aspect, which may be implemented in conjunction with any one of the first to third aspects, content of the silica in the silica-treated magnesium hydroxide falls within a range from 1 part by mass to 10 parts by mass with respect to 100 parts by mass of the magnesium hydroxide.

According to this aspect, setting the content of the silica at 1 part by mass or more allows the surface of the magnesium hydroxide to be treated sufficiently, thus reducing the chances of removing smear excessively through the desmear process. On the other hand, setting the content of the silica at 10 parts by mass or less may not only curb a decrease in flame retardance but also reduce the chances of causing the ion migration.

In a resin composition according to a fifth aspect, which may be implemented in conjunction with any one of the first to fourth aspects, the phosphorus-containing epoxy resin has, in its molecule, a structure expressed by the following Formula (1) and/or a structure expressed by the following Formula (2):

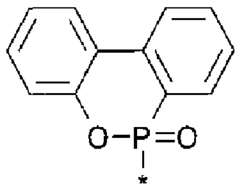

(1)

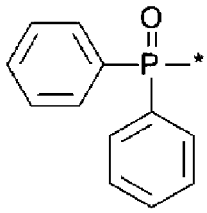

(2)

where * indicates a bond.

This aspect may contribute to further improving the flame retardance.

In a resin composition according to a sixth aspect, which may be implemented in conjunction with any one of the first to fifth aspects, the phosphorus-containing epoxy resin has a naphthalene structure.

This aspect may contribute to further improving the heat resistance.

In a resin composition according to a seventh aspect, which may be implemented in conjunction with any one of the first to sixth aspects, the phosphorus-containing epoxy resin has a structure expressed by the following Formula (3):

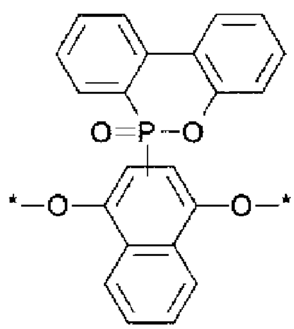

(3)

where * indicates a bond.

This aspect may contribute to further improving the flame retardance and the heat resistance.

A prepreg (1) according to an eighth aspect includes: a resin layer (11) containing the resin composition according to any one of the first to seventh aspects; and a base member (12) impregnated with the resin composition.

This aspect may contribute to reducing the chances of causing the ion migration and thereby improving the drillability, desmear performance, and flame retardance.

A film (2) with resin according to a ninth aspect includes: a resin layer (21) containing the resin composition according to any one of the first to seventh aspects; and a supporting film (22) to support the resin layer (21).

This aspect may contribute to reducing the chances of causing the ion migration and thereby improving the drillability, desmear performance, and flame retardance.

A sheet of metal foil (3) with resin according to a tenth aspect includes: a resin layer (31) containing the resin composition according to any one of the first to seventh aspects; and a sheet of metal foil (32) bonded to the resin layer (31).

This aspect may contribute to reducing the chances of causing the ion migration and thereby improving the drillability, desmear performance, and flame retardance.

A metal-clad laminate (4) according to an eleventh aspect includes: an insulating layer (41) containing either a cured product of the resin composition according to any one of the first to seventh aspects or a cured product of the prepreg according to the eighth aspect; and a metal layer (43) bonded to the insulating layer (41).

This aspect may contribute to reducing the chances of causing the ion migration and thereby improving the drillability, desmear performance, and flame retardance.

A printed wiring board (5) according to a twelfth aspect includes: an insulating layer (51) containing either a cured product of the resin composition according to any one of the first to seventh aspects or a cured product of the prepreg according to the eighth aspect; and conductor wiring (53) bonded to the insulating layer (51).

This aspect may contribute to reducing the chances of causing the ion migration and thereby improving the drillability, desmear performance, and flame retardance.

## Examples

The present disclosure will be described specifically by way of examples. Note that the present disclosure is not limited to the following examples.

[Materials]

The following materials were used as materials for resin compositions representing specific examples and comparative examples.

<<Epoxy resins>>

- Phosphorus-containing epoxy resin having the structure expressed by Formula (1), product name: FX-289 manufactured by Nippon Steel Chemical & Material Co., Ltd., phosphorus content: 2.2% by mass, epoxy equivalent: 310 g/eq;
- Bisphenol A type epoxy resin, product name: EPICLON 860 manufactured by DIC Corporation, phosphorus content: 0% by mass, epoxy equivalent: 245 g/eq; and
- Cresol novolac type epoxy resin, product name: EPICLON N-680 manufactured by DIC Corporation, phosphorus content: 0% by mass, epoxy equivalent: 210 g/eq.

<<Curing agents>>

- Dicyandiamide (DICY), amine equivalent: 21 g/eq; and
- Novolac type phenolic resin, product name: TD-2090 manufactured by DIC Corporation, hydroxyl group equivalent: 105 g/eq.

<<Inorganic fillers>>

- Aluminum hydroxide, product name: CL-303 manufactured by Sumitomo Chemical Co., Ltd., mean particle size: 4 μm;
- Silica-treated magnesium hydroxide, product name: Magseas EP-1S manufactured by Konoshima Chemical Co.,

Ltd., mean particle size: 2 μm;

- Magnesium hydroxide (not surface-treated with silica), product name: KISUMA 8 manufactured by Kyowa Chemical Industry Co., Ltd., mean particle size: 1.5 μm; and
- Fused silica, product name: FLB-2 manufactured by Tatsumori Ltd., mean particle size: 1.4 μm.

<<Curing accelerator>>

- 2-ethyl-4-methylimidazole (2E4MZ).

[Preparation of varnish]

These materials were blended to have any of the compositions shown in Tables 1 and 2. The blend was dissolved or dispersed in methyl ethyl ketone as a solvent so that the solid content would be 70% by mass. Then, the mixture was stirred up with a disper. In this manner, varnishes respectively containing the resin compositions according to the examples and comparative examples were prepared.

[Manufacturing of prepreg]

A prepreg was manufactured by using a piece of glass cloth (product name "#7628" manufactured by Nanya) as a base member, impregnating the piece of glass cloth with the varnish described above, and then heating the piece of glass cloth at a temperature of about 160°C for 4 to 5 minutes with a non-contact type heating unit and thereby drying and removing the solvent from the varnish to semi-cure the resin composition. The prepreg was prepared to have a resin content of 50% by mass.

[Manufacturing of copper-clad laminate]

Four prepregs, each of which was manufactured as described above, were stacked one on top of another, and the stack of the prepregs was sandwiched between the roughened surfaces of two sheets of copper foil (with a thickness of 35 μm) and heated and press-molded at a temperature of 180°C and under a pressure of 2.94 MPa (= 30 $kgf/cm^2$) for 90 minutes. In this manner, a copper-clad laminate (CCL), of which the insulating layer had an overall thickness of 800 μm, was manufactured.

[Evaluation tests]

(Glass transition temperature (Tg))

The sheets of copper foil of the copper-clad laminate were removed by etching to obtain an insulating substrate not covered with any sheet of copper foil (i.e., a so-called "unclad plate"). A disk-shaped sample was cut out from this insulating substrate. After this sample was dried, the glass transition temperature (Tg) was measured by DSC method. The measurement temperature was in the range from 30°C to 220°C and the temperature increase rate was 20°C/min. Tg was defined to be a temperature at an endothermic peak indicating a phase transition from the glass state to the rubber state in a DSC curve.

(Gel time)

About 10 mL of the varnish was dripped onto a hot plate at 170°C and then held for 20 seconds. After that, the time it took for the varnish to turn no longer thready from a Teflon® rod due to a sufficient increase in its viscosity since the varnish started to be stirred with the Teflon rod was measured.

(Coefficient of linear expansion (CTE-Z))

The sheets of copper foil of the copper-clad laminate were removed by etching to obtain an unclad plate, from which a disk-shaped sample was cut out. After the sample was dried, the coefficient of linear expansion (CTE-Z) in the thickness direction of the sample at a temperature equal to or lower than the glass transition temperature (Tg) was measured by TMA method. The measurement temperature was in the range from 30°C to 290°C and the temperature increase rate was 10°C/min. The sample was graded based on the following criteria:

Grade A: if the coefficient of linear expansion was equal to or less than 40 ppm/°C;
Grade B: if the coefficient of linear expansion fell within the range from more than 40 ppm/°C to 50 ppm/°C; or
Grade C: if the coefficient of linear expansion was more than 50 ppm/°C.

(Oven heat resistance)

The copper-clad laminate was cut into a plurality of pieces, each of which had a size of 5 cm square and was used as a sample. This sample was loaded into an oven at 250°C for 1 hour to see, with the naked eye, if any swelling had occurred to the sample. As used herein, the "swelling" refers to partially raised peeling that occurs between the insulating layers or between the insulating layer and the sheet of copper foil in the sample and is a form of delamination. The sample was graded based on the following criteria:

Grade A: if no swelling was observed;
Grade B: if swelling was observed at one or two points; or
Grade C: if swelling was observed at three or more points.

(Drillability)

Four copper-clad laminates, each of which was manufactured as described above, were stacked one on top of another and sandwiched between an entry board and a backup board. Then, the assembly was drilled with a drill bit attached to a drilling machine. The drilling was performed under the following condition:

Entry board: aluminum board (thickness: 0.15 mm);
Backup board: Bakelite board (thickness: 1.5 mm);
Drill bit: "NHU-L020" manufactured by Union Tool Co. (blade diameter: 0.3 mm, blade length 5.5 mm);
Number of revolutions: 160,000 rpm;
Feed rate: 3.2 m/min;
Tip load: 20 μm/rev; and
Number of hits: 3000.

Then, the drill wear rate (W) was calculated by the following formula:

$$W = (S1 - S2) \times 100/S1$$

where S1 is the area of a blade portion before drilling and S2 is the area of the blade portion after drilling.

As used herein, the blade portion refers to a part that directly contributes to cutting. The area of the blade portion herein refers to the area of the blade portion in an image captured by shooting the drill bit from its tip. The sample was graded based on the following criteria:

Grade A: if the drill wear rate was less than 50%; or
Grade B if the drill wear rate was equal to or greater than 50%.

(Desmear performance)

The sheets of copper foil of the copper-clad laminate were removed by etching to obtain a substrate under test (as an unclad plate). This substrate under test was subjected to a desmear process once under the FR4 condition with a desmear process liquid (product name: MLB213 manufactured by Roam and Haas Co.). Then, the weight of the substrate under test that had gone through the desmear process was measured, and the weight loss ($mg/dm^2$) through the desmear process was calculated based on the weight of the substrate under test after the desmear process and the weight of the substrate under test before the desmear process. The sample was graded based on the following criteria:

Grade A: if the weight loss was in the range from 5 $mg/dm^2$ to 15 $mg/dm^2$; or
Grade B: if the weight loss was either less than 5 $mg/dm^2$ or more than 15 $mg/dm^2$.

(CAF resistance)

Wiring having 50 through holes at a pitch of 1.65 mm was formed on the copper-clad laminate to prepare a sample. The distance between the inner walls of the through holes was 0.6 mm. A voltage of 500 V was applied to this sample for 1,000 hours in an atmosphere with a temperature of 85°C and a humidity of 85% RH. The resistance value (initial value) of the insulating layer before the application of the voltage and the resistance value of the insulating layer after the application of the voltage were measured. Then, the sample was graded by CAF resistance based on the following criteria:

Grade S: if the decrease in resistance value from the initial value was within one digit;
Grade A: if the decrease in resistance value from the initial value was two digits;
Grade B: if the decrease in resistance value from the initial value was three digits; or
Grade C: if the decrease in resistance value from the initial value was four digits or more.

(Copper foil adhesion)

The copper foil adhesion (peel strength) of the copper-clad laminate was measured in compliance with the JIS C6481 standard.

(Flame retardance)

A UL94 combustion test was conducted to evaluate the flame retardance. Specifically, the copper foils of the copper-clad laminate were removed by etching to obtain an unclad plate, from which a strip-shaped sample having a length of 125 mm and a width of 12.5 mm was cut out. This sample was attached vertically to a clamp and was exposed to 20 mm flames for 10 seconds twice. Based on its combustion behavior, the sample was graded V-0, V-1, V-2, or Not.
The results of these evaluation tests are summarized in the following Tables 1 and 2:

[Table 1]

| | | | Examples | | | | | | |
|---|---|---|---|---|---|---|---|---|---|
| | | | 1 | 2 | 3 | 4 | 5 | 6 | 7 |
| Chemical makeup (parts by mass) of resin composition | Epoxy Resin | FX-289 (phosphorus-containing epoxy resin) phosphorus content: 2.2% by mass epoxy equivalent: 310 g/eq | 98.2 | 97.0 | 96.7 | 96.7 | 96.7 | 96.7 | 96.7 |
| | | EPICLON 860 phosphorus content: 0% by mass epoxy equivalent: 245 g/eq | 0 | 0 | 0 | 0 | 0 | 0 | 0 |
| | | EPICLON N-680 phosphorus content: 0% by mass epoxy equivalent: 210 g/eq | 0 | 0 | 0 | 0 | 0 | 0 | 0 |
| | Curing Agent | DICY (dicyandiamide) amine equivalent: 21 g/eq | 1.8 | 2.7 | 3.3 | 3.3 | 3.3 | 3.3 | 3.3 |
| | | TD-2090 hydroxyl group equivalent: 105 g/eq | 0 | 0 | 0 | 0 | 0 | 0 | 0 |
| | Curing Accelerator | 2E4MZ | 0.12 | 0.07 | 0.05 | 0.05 | 0.05 | 0.05 | 0.05 |
| | Inorganic Filler | CL-303 (aluminum hydroxide) | 52.0 | 52.0 | 52.0 | 35.0 | 75.0 | 69.0 | 50.0 |
| | | Magseas EP-1S (silica-treated magnesium hydroxide) | 3.0 | 3.0 | 3.0 | 3.0 | 3.0 | 1.0 | 20.0 |
| | | KISUMA 8 (magnesium hydroxide) | 0 | 0 | 0 | 0 | 0 | 0 | 0 |
| | | FLB-2 (fused silica) | 0 | 0 | 0 | 0 | 0 | 0 | 0 |
| Total (equivalent) of active hydrogen groups in curing agent to 1 eq. of epoxy group in epoxy resin | | | 0.27 | 0.41 | 0.50 | 0.50 | 0.50 | 0.50 | 0.50 |
| Test results | Glass transition temperature (Tg) (°C) | | 130 | 145 | 155 | 155 | 155 | 155 | 155 |
| | Gel time (min) | | 7 | 6 | 6 | 6 | 6 | 6 | 6 |
| | Coefficient of linear expansion (CTE-Z) | | A | A | A | B | A | A | A |
| | Oven heat resistance | | A | A | A | A | B | B | A |
| | Drillability | | A | A | A | A | A | A | A |
| | Desmear performance | | A | A | A | A | A | A | A |
| | CAF resistance | | S | S | S | S | S | A | S |
| | Copper foil adhesion (N/mm) | | 1.7 | 1.7 | 1.7 | 1.7 | 1.6 | 1.7 | 1.7 |
| | Flame retardance | | V-0 | V-0 | V-0 | V-0 | V-0 | V-0 | V-0 |

[Table 2]

| | | | Comparative examples | | | | | | | | |
|---|---|---|---|---|---|---|---|---|---|---|---|
| | | | 1 | 2 | 3 | 4 | 5 | 6 | 7 | 8 | 9 |
| Chemical makeup (parts by mass) of resin composition | Epoxy Resin | FX-289 (phosphorus-containing epoxy resin) phosphorus content: 2.2% by mass epoxy equivalent: 310 g/eq | 0 | 0 | 75.0 | 96.7 | 96.7 | 96.7 | 96.7 | 96.7 | 96.7 |
| | | EPICLON 860 phosphorus content: 0% by mass epoxy equivalent: 245 g/eq | 96.0 | 0 | 0 | 0 | 0 | 0 | 0 | 0 | 0 |
| | | EPICLON N-680 phosphorus content: 0% by mass epoxy equivalent: 210 g/eq | 0 | 96.0 | 0 | 0 | 0 | 0 | 0 | 0 | 0 |
| | Curing Agent | DICY (dicyandiamide) amine equivalent: 21 g/eq | 4.0 | 4.0 | 0 | 3.3 | 3.3 | 3.3 | 3.3 | 3.3 | 3.3 |
| | | TD-2090 hydroxyl group equivalent: 105 g/eq | 0 | 0 | 25.0 | 0 | 0 | 0 | 0 | 0 | 0 |
| | Curing Accelerator | 2E4MZ | 0.05 | 0.05 | 0.05 | 0.05 | 0.05 | 0.05 | 0.05 | 0.05 | 0.05 |
| | Inorganic Filler | CL-303 (aluminum hydroxide) | 52.0 | 52.0 | 52.0 | 50.0 | 70.0 | 50.0 | 0 | 20.0 | 100.0 |
| | | Magseas EP-1S (silica-treated magnesium hydroxide) | 3.0 | 3.0 | 3.0 | 0 | 0 | 0 | 0 | 3.0 | 3.0 |
| | | KISUMA 8 (magnesium hydroxide) | 0 | 0 | 0 | 20.0 | 0 | 0 | 45.0 | 0 | 0 |
| | | FLB-2 (fused silica) | 0 | 0 | 0 | 0 | 0 | 20.0 | 3.0 | 0 | 0 |
| Total (equivalent) of active hydrogen groups in curing agent to 1 eq. of epoxy group in epoxy resin | | | 0.49 | 0.42 | 0.98 | 0.50 | 0.50 | 0.50 | 0.50 | 0.50 | 0.50 |
| Test results | Glass transition temperature (Tg) (°C) | | 145 | 155 | 125 | 155 | 155 | 155 | 155 | 155 | 155 |
| | Gel time (min) | | 6 | 5 | 5 | 6 | 6 | 6 | 6 | 6 | 6 |
| | Coefficient of linear expansion (CTE-Z) | | A | A | A | A | A | A | A | C | A |
| | Oven heat resistance | | A | A | A | A | B | A | A | A | C |
| | Drillability | | A | A | A | A | A | B | A | A | B |
| | Desmear performance | | A | A | A | B | A | A | B | A | A |
| | CAF resistance | | S | S | S | S | D | D | S | S | S |
| | Copper foil adhesion (N/mm) | | 1.8 | 1.7 | 1.4 | 1.7 | 1.7 | 1.7 | 1.7 | 1.8 | 1.4 |
| | Flame retardance | | V-1 | V-1 | V-1 | V-0 | V-0 | V-0 | V-1 | V-1 | V-0 |

**Reference Signs List**

1 Prepreg
11 Resin Layer
12 Base Member
2 Film with Resin
21 Resin Layer
22 Supporting Film
3 Sheet of Metal Foil with Resin
31 Resin Layer

32 Sheet of Metal Foil
4 Metal-Clad Laminate
41 Insulating Layer
43 Metal Layer
5 Printed Wiring Board
51 Insulating Layer
53 Conductor Wiring

## Claims

1. A resin composition containing an epoxy resin, a curing agent, and an inorganic filler, the epoxy resin including a phosphorus-containing epoxy resin,

   the curing agent including dicyandiamide,
   the inorganic filler including: a silica-treated magnesium hydroxide that is a magnesium hydroxide subjected to surface treatment with silica; and aluminum hydroxide,
   total content of the silica-treated magnesium hydroxide and the aluminum hydroxide falling within a range from 30 parts by mass to 80 parts by mass with respect to 100 parts by mass in total of the epoxy resin and the curing agent.

2. The resin composition of claim 1, wherein
   a total amount of active hydrogen groups in the curing agent falls within a range from 0.2 equivalents to 0.5 equivalents with respect to 1 equivalent of an epoxy group in the epoxy resin.

3. The resin composition of claim 1 or 2, wherein
   content of the silica-treated magnesium hydroxide falls within a range from 1 part by mass to 50 parts by mass with respect to 100 parts by mass in total of the silica-treated magnesium hydroxide and the aluminum hydroxide.

4. The resin composition of any one of claims 1 to 3, wherein
   content of the silica in the silica-treated magnesium hydroxide falls within a range from 1 part by mass to 10 parts by mass with respect to 100 parts by mass of the magnesium hydroxide.

5. The resin composition of any one of claims 1 to 4, wherein
   the phosphorus-containing epoxy resin has a structure expressed by the following Formula (1) and/or a structure expressed by the following Formula (2):

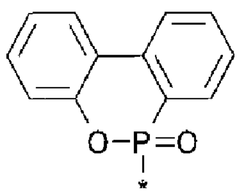

(1)

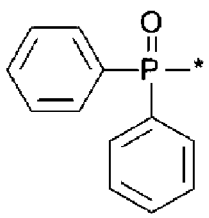

(2)

   where * indicates a bond.

6. The resin composition of any one of claims 1 to 5, wherein

the phosphorus-containing epoxy resin has a naphthalene structure.

**7.** The resin composition of any one of claims 1 to 6, wherein
the phosphorus-containing epoxy resin has a structure expressed by the following Formula (3):

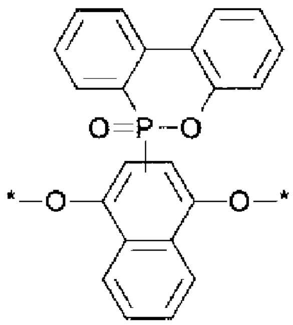

(3)

where * indicates a bond.

**8.** A prepreg comprising:

a resin layer containing the resin composition of any one of claims 1 to 7; and
a base member impregnated with the resin composition.

**9.** A film with resin, comprising:

a resin layer containing the resin composition of any one of claims 1 to 7; and
a supporting film to support the resin layer.

**10.** A sheet of metal foil with resin, comprising:

a resin layer containing the resin composition of any one of claims 1 to 7; and
a sheet of metal foil bonded to the resin layer.

**11.** A metal-clad laminate comprising:

an insulating layer containing either a cured product of the resin composition of any one of claims 1 to 7 or a cured product of the prepreg of claim 8; and
a metal layer bonded to the insulating layer.

**12.** A printed wiring board comprising:

an insulating layer containing either a cured product of the resin composition of any one of claims 1 to 7 or a cured product of the prepreg of claim 8; and
conductor wiring bonded to the insulating layer.

**Patentansprüche**

**1.** Harzzusammensetzung, enthaltend ein Epoxidharz, ein Härtungsmittel und ein anorganisches Füllmaterial,

wobei das Epoxidharz ein phosphorhaltiges Epoxidharz enthält,
wobei das Härtungsmittel Dicyandiamid enthält,
wobei das anorganische Füllmaterial ein siliziumdioxidbehandeltes Magnesiumhydroxid, bei dem es sich um ein Magnesiumhydroxid, das einer Oberflächenbehandlung mit Siliziumdioxid unterzogen wurde, handelt, und Aluminiumhydroxid enthält,
wobei der gesamte Gehalt des siliziumdioxidbehandelten Magnesiumhydroxids und des Aluminiumhydroxids in einen Bereich von 30 Masseteilen bis 80 Masseteilen in Bezug auf insgesamt 100 Masseteile des Epoxidharzes und des Härtungsmittels fällt.

2. Harzzusammensetzung nach Anspruch 1, wobei eine Gesamtmenge der aktiven Wasserstoffgruppen in dem Härtungsmittel in einen Bereich von 0,2 Äquivalenten bis 0,5 Äquivalenten in Bezug auf 1 Äquivalent einer Epoxidgruppe in dem Epoxidharz fällt.

3. Harzzusammensetzung nach Anspruch 1 oder 2, wobei der Gehalt des siliziumdioxidbehandelten Magnesiumhydroxids in einen Bereich von 1 Masseteil bis 50 Masseteilen in Bezug auf insgesamt 100 Masseteile des siliziumdioxidbehandelten Magnesiumhydroxids und des Aluminiumhydroxids fällt.

4. Harzzusammensetzung nach einem der Ansprüche 1 bis 3, wobei der Gehalt des Siliziumdioxids in dem siliziumdioxidbehandelten Magnesiumhydroxid in einen Bereich von 1 Masseteil bis 10 Masseteilen in Bezug auf 100 Masseteile des Magnesiumhydroxids fällt.

5. Harzzusammensetzung nach einem der Ansprüche 1 bis 4, wobei das phosphorhaltige Epoxidharz eine durch die folgende Formel (1) ausgedrückte Struktur und/oder eine durch die folgende Formel (2) ausgedrückte Struktur aufweist:

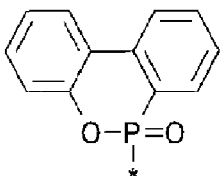

(1)

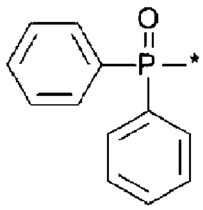

(2)

wobei * eine Bindung angibt.

6. Harzzusammensetzung nach einem der Ansprüche 1 bis 5, wobei das phosphorhaltige Epoxidharz eine Naphthalen-Struktur aufweist.

7. Harzzusammensetzung nach einem der Ansprüche 1 bis 6, wobei das phosphorhaltige Epoxidharz eine durch die folgende Formel (3) ausgedrückte Struktur aufweist:

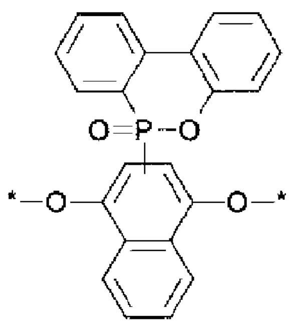

(3)

wobei * eine Bindung angibt.

**8.** Prepreg, aufweisend

eine Harzschicht, die die Harzzusammensetzung nach einem der Ansprüche 1 bis 7 enthält; und
ein Basiselement, das mit der Harzzusammensetzung getränkt ist.

**9.** Film mit einem Harz, aufweisend

eine Harzschicht, die die Harzzusammensetzung nach einem der Ansprüche 1 bis 7 enthält; und
einen Trägerfilm zum Tragen der Harzschicht.

**10.** Bogen einer Metallfolie mit einem Harz, aufweisend

eine Harzschicht, die die Harzzusammensetzung nach einem der Ansprüche 1 bis 7 enthält; und
einen an die Harzschicht gebundenen Bogen einer Metallfolie.

**11.** Metallbeschichtetes Laminat, aufweisend

eine Isolierschicht, die entweder ein Härtungsprodukt der Harzzusammensetzung nach einem der Ansprüche 1 bis 7 oder ein Härtungsprodukt des Prepregs nach Anspruch 8 enthält; und
eine an die Isolierschicht gebundene Metallschicht.

**12.** Leiterplatte, aufweisend

eine Isolierschicht, die entweder ein Härtungsprodukt der Harzzusammensetzung nach einem der Ansprüche 1 bis 7 oder ein Härtungsprodukt des Prepregs nach Anspruch 8 enthält; und
eine an die Isolierschicht gebundene Leiterverdrahtung.

**Revendications**

**1.** Composition de résine contenant une résine époxy, un agent durcisseur, et une charge inorganique,

la résine époxy incluant une résine époxy contenant du phosphore,
l'agent durcisseur incluant du dicyanodiamide,
la charge inorganique incluant : un hydroxyde de magnésium traité à la silice qui est un hydroxyde de magnésium ayant subi un traitement de surface avec de la silice ; et de l'hydroxyde d'aluminium,
la teneur totale en l'hydroxyde de magnésium traité à la silice et de l'hydroxyde d'aluminium étant située dans la plage allant de 30 parties en masse à 80 parties en masse pour 100 parties en masse au total de la résine époxy et de l'agent durcisseur.

**2.** Composition de résine selon la revendication 1, dans laquelle
la quantité totale des groupes hydrogène réactifs dans l'agent durcisseur est située dans la plage allant de 0,2 équivalent à 0,5 équivalent pour 1 équivalent de groupe époxy dans la résine époxy.

**3.** Composition de résine selon la revendication 1 ou 2, dans laquelle
la teneur en l'hydroxyde de magnésium traité à la silice est située dans la plage allant de 1 partie en masse à 50 parties en masse pour 100 parties en masse au total de l'hydroxyde de magnésium traité à la silice et de l'hydroxyde d'aluminium.

**4.** Composition de résine selon l'une quelconque des revendications 1 à 3, dans laquelle
la teneur en la silice de l'hydroxyde de magnésium traité à la silice est située dans la plage allant de 1 partie en masse à 10 parties en masse pour 100 parties en masse de l'hydroxyde de magnésium.

**5.** Composition de résine selon l'une quelconque des revendications 1 à 4, dans laquelle
la résine époxy contenant du phosphore a une structure représentée par la formule (1) qui suit et/ou une structure représentée par la formule (2) qui suit :

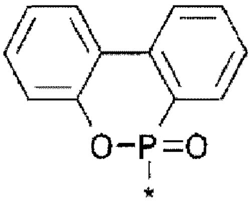

(1)

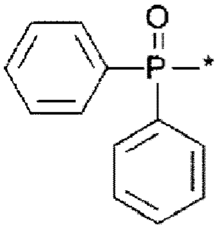

(2)

où * indique une liaison.

6. Composition de résine selon l'une quelconque des revendications 1 à 5, dans laquelle la résine époxy contenant du phosphore a une structure de naphtalène.

7. Composition de résine selon l'une quelconque des revendications 1 à 6, dans laquelle la résine époxy contenant du phosphore a une structure représentée par la formule (3) qui suit :

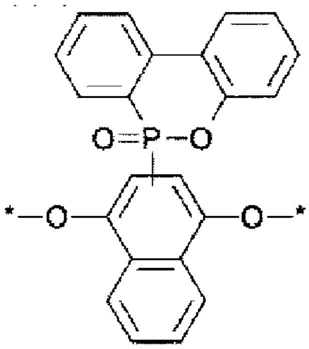

(3)

où * indique une liaison.

8. Préimprégné comprenant :

une couche de résine contenant la composition de résine de l'une quelconque des revendications 1 à 7 ; et un élément de base imprégné de la composition de résine.

9. Film avec résine comprenant :

une couche de résine contenant la composition de résine de l'une quelconque des revendications 1 à 7 ; et un film de support pour supporter la couche de résine.

10. Tôle de feuille métallique avec résine comprenant :

une couche de résine contenant la composition de résine de l'une quelconque des revendications 1 à 7 ; et une tôle de feuille métallique collée à la couche de résine.

**11.** Stratifié métallisé comprenant :

une couche isolante contenant soit un produit durci de la composition de résine de l'une quelconque des revendications 1 à 7 soit un produit durci du préimprégné de la revendication 8 ; et
une couche métallique collée à la couche isolante.

**12.** Carte de circuit imprimé comprenant :

une couche isolante contenant soit un produit durci de la composition de résine de l'une quelconque des revendications 1 à 7 soit un produit durci du préimprégné de la revendication 8 ; et
un câblage conducteur collé à la couche isolante.

FIG. 1

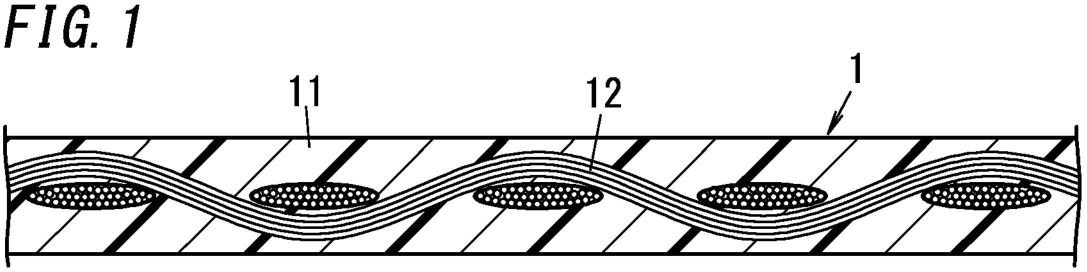

FIG. 2A

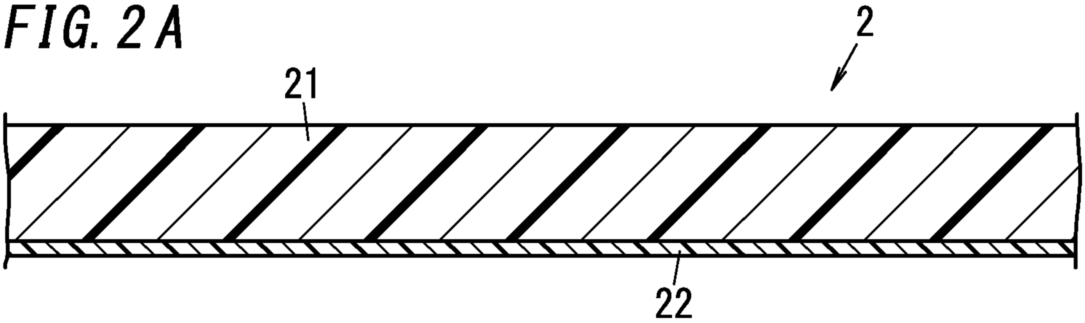


FIG. 2B

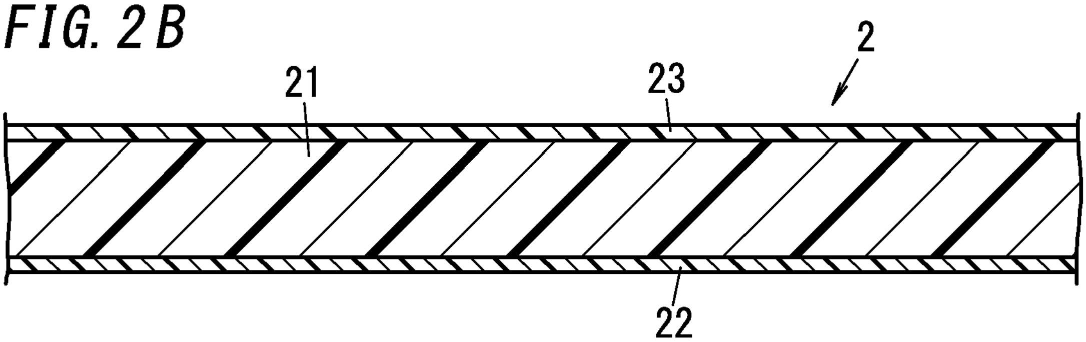

FIG. 3

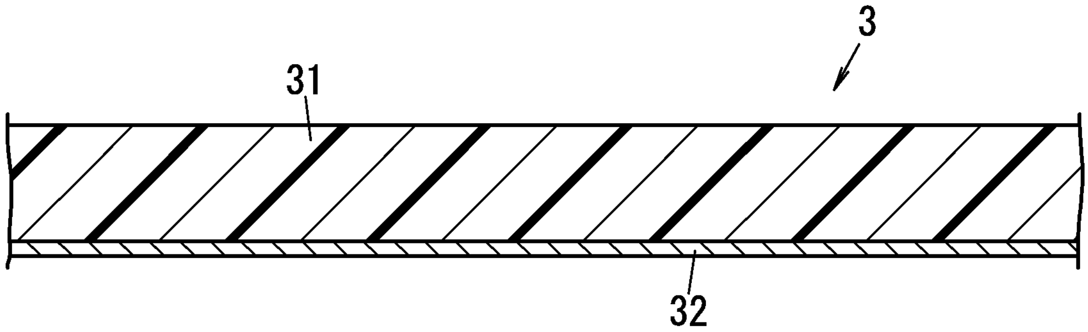

FIG. 4

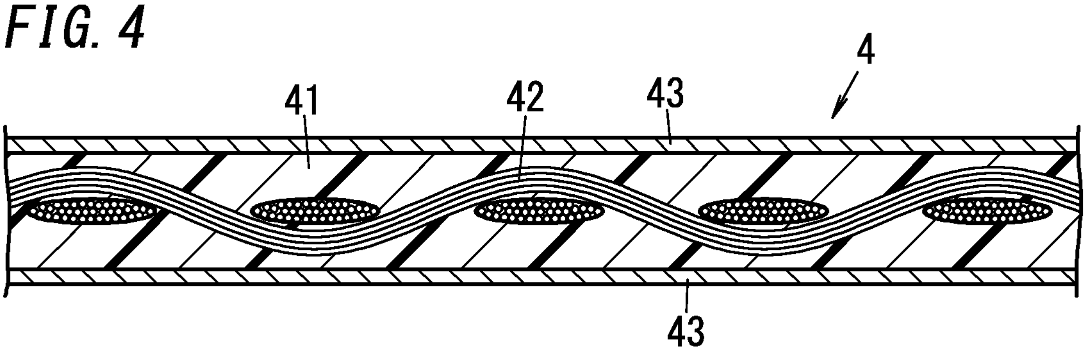

FIG. 5

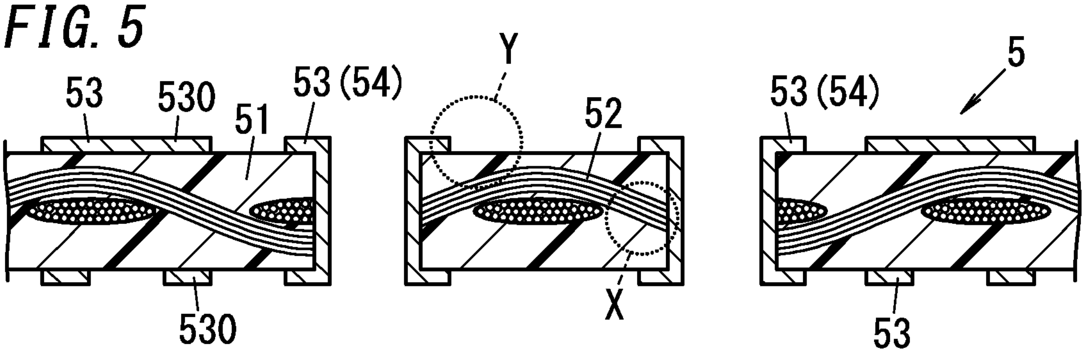

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2011118584 A1